# EUROPEAN PATENT SPECIFICATION

(11) **EP 0 427 254 B1**
(45) Date of publication and mention of the grant of the patent: **29.01.1997**
(21) Application number: 90121381.9
(22) Date of filing: 08.11.1990
(51) Int. Cl.: H01L 21/768, H01L 21/285

(54) **Method for forming a contact region**
Verfahren zum Herstellen einer Kontaktzone
Procédé pour la fabrication d'une région de contact

(30) Priority: 10.11.1989 JP 293290/89
(43) Date of publication of application: 15.05.1991
(73) Proprietor: KABUSHIKI KAISHA TOSHIBA, Kawasaki-shi, Kanagawa-ken 210 (JP)
(72) Inventor: Yoda, Takashi, Intellectual Property Division, Minato-ku, Tokyo 105 (JP); Watanabe, Tohru, Intellectual Property Division, Minato-ku, Tokyo 105 (JP)
(74) Representative: Lehn, Werner, Dipl.-Ing.

(56) References cited:
- US-A- 4 690 730
- IBM TECHNICAL DISCLOSURE BULLETIN. vol. 30, no. 8, January 1988, NEW YORK US pages 343 - 344; 'ETCH STOP MATERIALS AND PROCESS FOR REACTIVE ION ETCHING OF ALUMINIUM COPPER'
- PROCS. 1985 IEEE VLSI MULTILEVEL INTERCONECTION CONF. SANTA CLARA C.A., P357-
- 62, 25-26/6/1985 W. METZ & E. BEAM "LPCVD TUNGSTEN METALLISATION FOR MULTILEVEL INTERCONNECT PROCESSES"
- IEEE TRANSACTIONS ON ELECTRON DEVICES. vol. 35, no. 12, December 1988, NEW YORK US pages 2328 - 2332; MASANORI FUKUMOTO ET.AL.: 'TITANIUM SILICIDE INTERCONNECT TECHNOLOGY FOR SUBMICRON DRAM'S'
- J.Vacuum Sci. and Tech. vol. 17, No. 4, 1980, by S.P. Murarka.
- IEDM Technical Digest, CH-1973-7, 1983, pages 550-553 by T. Moriya et al.

## Description

The present invention relates to a method for forming contact regions in a semiconductor device having an active element and/or passive element formed in a semiconductor substrate comprising silicon, and more particularly to such a method for forming contact regions which allows the formation of a wiring or interconnection layer of good quality even in a contact hole of a greater aspect ratio.

For a very small metal wiring or interconnection layer for LSI's, use has been made of aluminum, or aluminum alloys such as Aℓ-Si and Aℓ-Si-Cu alloys. These aluminum-based materials are usually deposited by sputtering so as to form interconnection layers. If, however, an Aℓ-based layer is formed by such a sputtering in a contact hole of a greater aspect ratio (that is, a ratio of the depth to the width of the opening of the contact hole), more Aℓ-based material is deposited on the upper inner edge of the contact hole to provide a thickened portion. The presence of such a thickened portion causes a "shadowing" phenomenon, producing a lowering of a step coverage at the Aℓ-based layer. As a result, the Aℓ-based material is thinly deposited in the inner edge of the contact hole and, in a worst case, a breakage occurs in the Aℓ-based material layer at the bottom corner of the contact hole.

In order to solve the aforementioned problem, a conductive material is embedded on the bottom of the contact hole if the contact hole has a greater aspect ratio. By so doing, the aspect ratio is substantially lowered in actual practice. One approach to this problem is to deposit tungsten by a chemical vapor deposition (CVD) method in the contact hole over the semiconductor substrate. Tungsten is usually deposited there through a vapor phase reaction of a tungsten halide (feed gas) with a reducing agent such as hydrogen or silane.

The formation of contact holes involves forming an insulating layer by a thermal oxidation on the surface of a semiconductor silicon substrate having predetermined semiconductor regions formed in the surface portion thereof. Then contact holes are formed in the insulating layer, by a photolithography method, partially exposing the semiconductor regions. Then an impurity of a given concentration is introduced in a relatively high impurity level in the exposed surface portion of the substrate at those areas of the contact holes to provide impurity areas for taking an ohmic contact.

When tungsten is deposited by the CVD method in the contact hole thus provided, a problem as will be set forth below is encountered. The deposited tungsten reacts relatively vigorously with the silicon in the substrate, consuming the silicon in the substrate. This reaction progresses not only vertically but also laterally down the insulating layer, causing the degradation of the electrical properties of a semiconductor device (final product), such as leakage of a current at PN junctions. This phenomenon occurs severely at a high concentration N type (N⁺) impurity region in particular.

Further, the tungsten layer as deposited in the contact hole usually reveals a feeble bond to the underlying semiconductor silicon substrate. A native oxide film readily tends to be formed on the surface of the P⁺ region in particular. The presence of the native oxide film has a greater tendency for the tungsten layer's bond to be weakened and, as a result, the resultant semiconductor device manifests a degradation in its properties, such as an increased electrical resistance at the contact region.

In the technique of achieving a substantially smaller aspect ratio by forming a tungsten layer by the CVD method in the contact hole, the property of the tungsten layer largely depends upon the type of impurity, its concentration level or its surface state in the underlying semiconductor silicon substrate.

IBM Technical Disclosure Bulletin, Vol. 30, No. 8, Jan 1988, p343-344 shows forming a silicide layer as a protective barrier for the silicon substrate during RIE etching. A thin layer of tungsten is formed by sputtering to improve the reliability of an AlCuSi conductor.

IEDM technical digest CH-1973-7, 1983, p. 550-553 shows refilling contact windows or via holes with tungsten by selective CVD employing WF₆, at a temperature of 350°C. However, these is no disclosure of forming a transition metal layer, or a silicide layer through reaction of the transition metal layer with exposed silicon.

It is accordingly an object of the present invention to provide a method for forming contact regions which enable a tungsten layer to be formed in a contact hole by a CVD method without being substantially affected by an underlying substrate and hence enable a semiconductor device to be manufactured as a device of an excellent electrical property.

According to the present invention, there is provided a method as set out in claim 1.

This invention can be more fully understood from the following detailed description when taken in conjunction with the accompanying drawings, in which:
Figs. 1A to 1E show the steps of forming contact regions according to one embodiment of the present invention;
Figs. 2A to 2C show the steps of forming contact regions according to another embodiment of the present invention; and
Figs. 3A to 3C show the steps of forming contact regions according to still another embodiment of the present invention.

According to still another aspect of the present invention there is provided a method for forming a contact region, comprising the steps of:
forming an insulating layer on a semiconductor substrate having a predetermined semiconductor area in a major surface portion thereof, the semiconductor substrate comprising silicon;
providing a contact hole in the insulating layer, partially exposing the semiconductor region;
vapor-depositing transition metal particles in a direction substantially perpendicular to the major surface of the semiconductor substrate to form a transition metal layer on the insulating layer and on the semiconductor region exposed in the contact hole;
forming a silicide layer through a reaction of the transition metal layer with the silicon of the substrate within the contact hole; and
forming a tungsten layer on the silicide layer.

This invention can be more fully understood from the following detailed description when taken in conjunction with the accompanying drawings, in which:

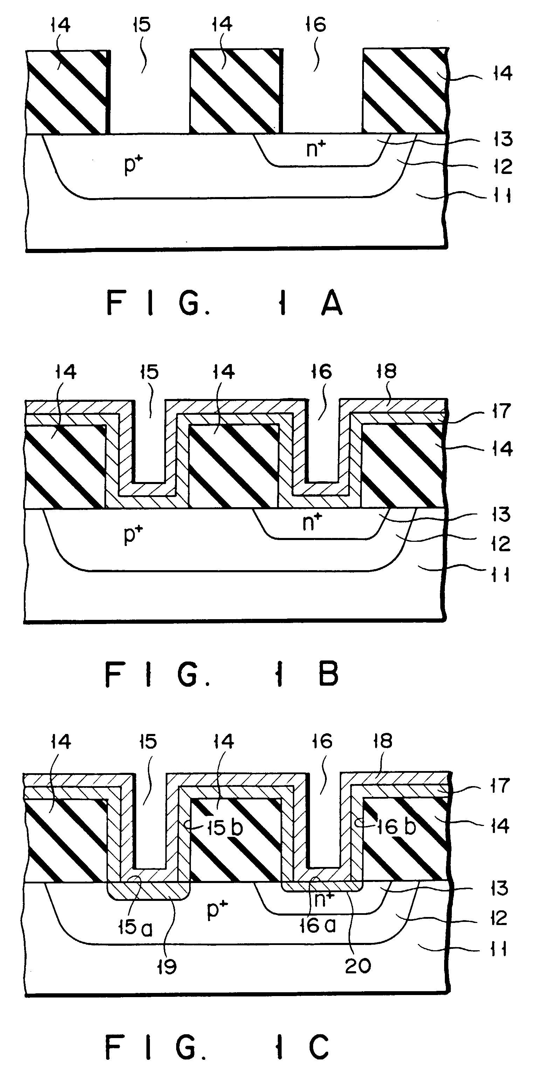

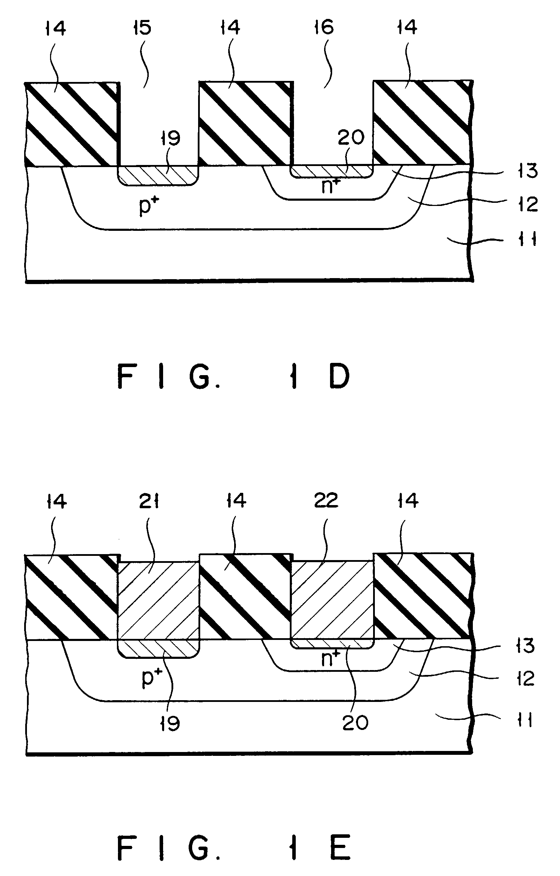

Figs. 1A to 1E show the steps of forming contact regions according to one embodiment of the present invention;

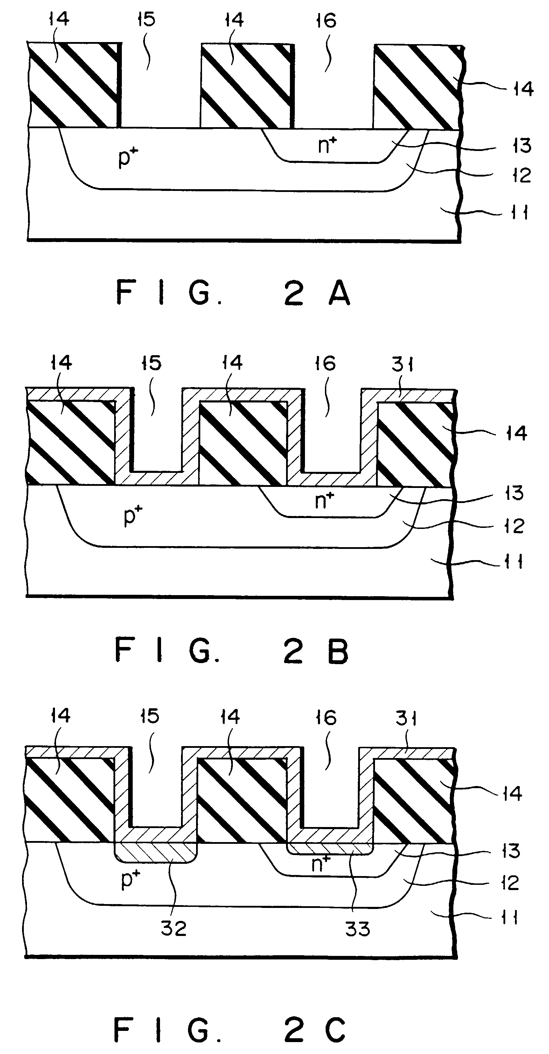

Figs. 2A to 2C show the steps of forming contact regions according to another embodiment of the present invention; and

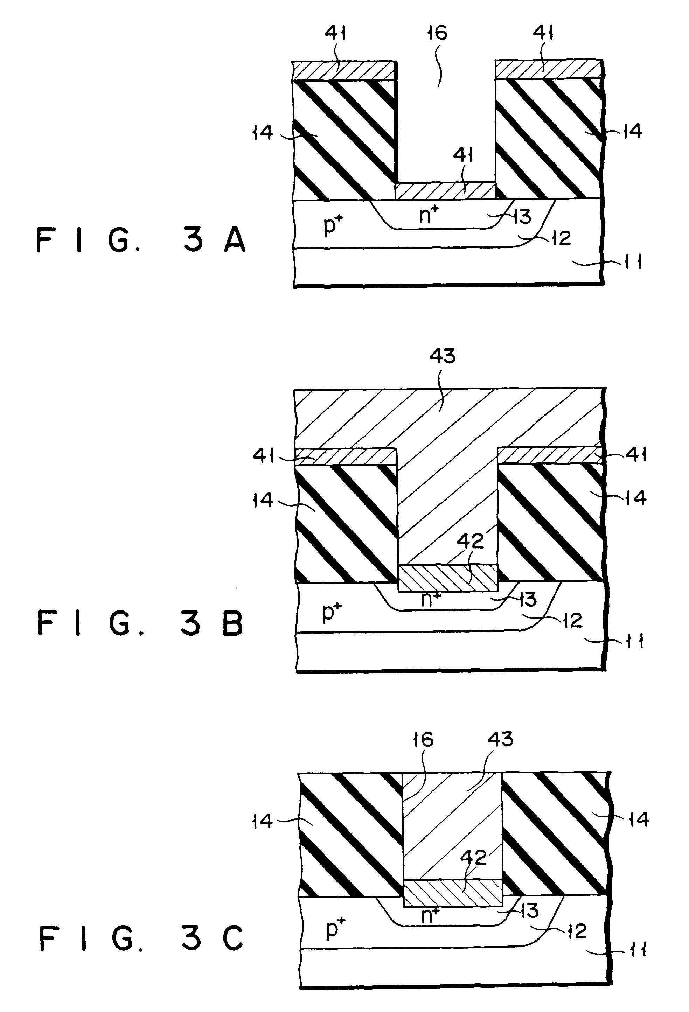

Figs. 3A to 3C show the steps of forming contact regions according to still another embodiment of the present invention.

The embodiments of the present invention will be explained below in more detail with reference to the drawings. Identical numerals are employed to designate similar parts or elements throughout the drawings.

### Embodiment 1

Referring to Fig. 1A, a P type impurity, such as BF₂, is selectively ion-implanted into a predetermined area of an N type silicon substrate 11 at a dose of 5 × 10¹⁵ cm⁻². The resultant structure is heat treated at a temperature of about 800°C to provide a P⁺ impurity region 12 of a predetermined diffusion depth. The impurity concentration of the P⁺ impurity region 12 is set in a range of, for example, 5 × 10¹⁹ /cm³.

An N type impurity, such as an As, is selectively ion-implanted in a predetermined portion of the P⁺ impurity region 12 at a dose of 5 × 10¹⁵ cm⁻². The resultant structure is heat treated at a temperature of about 800°C to provide an N⁺ impurity region 13. The impurity concentration of the N⁺ impurity region 13 is set at about 10²⁰ /cm³.

In this way, an element of a planar type structure is formed in the silicon substrate 11.

An insulating layer is formed on a major surface of the substrate 13 including the surfaces of the P⁺ impurity region 12 and N⁺ impurity region 13. The insulating layer is formed of, for example, SiO₂. Then contact holes 15 and 16 are formed by a photolithography method in the insulating layer to partially expose the surfaces of the P⁺ impurity region 12 and N⁺ impurity region 13. The remaining insulating layer 14 protects PN junction parts which would otherwise be exposed on the major surface of the semiconductor substrate 11.

As shown in Fig. 1B, a transition metal, such as titanium, is deposited, by a sputtering such as a magnetron sputtering, on the surface of the resultant structure, that is, the surface of the insulating layer 14 and exposed surfaces of the P⁺ impurity region 12 and N⁺ impurity region 13 at the contact holes 15 and 16. By so doing, a titanium layer 17 is formed on the surface of the aforementioned structure. The transition metal layer preferably has a thickness of 500 to 1500 Å (10 Å = 1 nm). In place of titanium, use may be made of other transition metals, such as nickel (Ni), cobalt (Co), tungsten (W). The transition metal layer can also be formed by a plating method.

Preferably, a layer 18 of a transition metal nitride, such as titanium nitride (TiN), is deposited on the titanium layer 17. The nitride layer 18 preferably has a thickness of 500 to 1500 Å. The titanium nitride layer 18 serves to make uniform a thickness of silicide layers 19 and 20 (Fig. 1C) to be formed through a reaction (silicidation) as will be set out below.

Then, resultant structure (Fig. 1B) is heat treated for 0.5 to 1.0 hours at a temperature of 600 to 700°C to conduct a reaction (silicidation) of the titanium in the titanium layer 17 with the substrate silicon. By so doing, as shown in Fig. 1C, titanium silicide layers 19 and 20 are formed beneath the bottoms 15a and 16a of the contact holes 15 and 16. In the course of the silicidation reaction above, those areas around the silicide layers 19 and 20 cause no substantial thickening of other areas owing to the presence of the titanium nitride layer 18, so that the silicide layers 19 and 20 are made to have a substantial uniform thickness as a whole. The transition metal layer conducts no reaction with the insulating layer SiO₂.

The arsenic (As) in the impurity region 13 has an effect of suppressing the aforementioned silicidation reaction. For this reason, the silicide layer 19 in the P⁺ impurity region 12 is thickened relative to the silicide layer 20 in the N⁺ impurity region 13.

Then the titanium layer 17 and titanium nitride layer 18, including those remaining on the side walls 15b and 16b of the contact holes 15 and 16, are selectively removed by an etchant, such as sulfuric acid, through their dissolution. As a result, the titanium silicide layers 19 and 20 are defined self-alignedly only at the bottoms 15a and 16a of the contact holes 15 and 16.

A mixed gas of a tungsten halide and a reducing agent is supplied over the resultant structure heated to a predetermined temperature, and tungsten layers 21, growing tungsten layers 21 and 22, as shown in Fig. 1E, on the titanium silicide layers 19 and 20 at the contact holes 15 and 16. As a tungsten halide, use can be made of a tungsten hexafluoride gas (WF₆). As a reducing agent, use can be made of a hydrogen gas, silane (SiH₄) gas. In this Embodiment, a mixture of SiH₄ and WF₆ gases was used and, in this case, the heating temperature of the silicon substrate structure is preferably in a range of 300 to 400°C. This is because a tungsten layer cannot be grown if the semiconductor silicon substrate 11 is held at a temperature less than 300°C and because a tungsten layer cannot be selectively grown on the titanium silicide layers 19 and 20 in the contact holes 15 and 16, if the semiconductor silicon substrate 11 is held at a temperature exceeding 400°C.

If the SiH₄/WF₆ gas flow ratio is 1.0 or less in the formation of the tungsten layers 21 and 22, these layers are selectively grown in the contact holes 15 and 16 only. If, on the other hand, the SiH₄/WF₆ gas flow ratio exceeds 1.0, the tungsten layer is grown in the contact holes 15 and 16 and also on the whole surface of the insulating layer 14. The whole surface of the tungsten layer can be selectively removed by an etch-back step to leave the tungsten layer as a buried layer only at the interior of the contact holes and 16.

After the tungsten layer has been so buried in the contact holes 15 and 16, a wiring or interconnection layer of aluminum or aluminum alloy, such as an Aℓ-Si or Aℓ-Si-Cu alloy, are formed by an ordinary process to connect with the corresponding contact regions comprising the tungsten layers 15 and 16, providing a semiconductor device.

In the formation of the contact region as described above, the silicide layers 19 and 20 are formed prior to the formation of the tungsten layers. It is thus possible to prevent a tungsten encroachment which has been encountered when a tungsten layer is formed directly on the semiconductor silicon substrate structure. The silicide layers 19 and 20 provide a strong bond to the tungsten layers 21 and 22 and reveal a better shape integrity. Thus, the tungsten layers 21 and 22 of a better quality can be provided over the semiconductor substrate structure without being influenced by the type and concentration level of an impurity in the semiconductor silicon substrate (underlying layer structure). As a result, it is possible to provide excellent contact regions which can provide a device of excellent electrical properties, such as low contact resistance and junction leakage.

Stated more specifically, the resistance of the contact regions of a tungsten layer buried in contact holes of 1 µm was as small as 50 to 60 Ω according to the present invention, a value very much smaller than 1000 Ω for a conventional case where a tungsten layer is formed directly on the substrate through a hydrogen reduction of WF₆.

For the junction leakage current it has been found that a leakage current is of the order of 10⁻¹⁰ to 10⁻¹¹ A for the contact region formed according to the present invention and of the order of 10⁻⁷ to 10⁻⁸ A for the conventional contact region.

### Embodiment 2

As shown in Fig. 2A, an impurity region 12 and an impurity region 13 are formed at predetermined locations in the semiconductor silicon substrate 11 as in Embodiment 1. Then an insulating layer 14 is formed on a major surface of the semiconductor substrate 11 to cover the impurity region 12 and impurity impurity 13, as in Embodiment 1. Contact holes 15 and 16 are formed in the insulating layer 14 to expose the impurity regions 12 and 13, as in Embodiment 1.

Then a titanium layer 31 is formed by a magnetron sputtering on the insulating layer 14 and in contact holes 15 and 16 of the silicon substrate 11, as shown in Fig. 2B. The titanium layer 31 preferably has a thickness of 500 to 1500 Å.

A uniform plasma is generated, by a magnetron sputtering, between the target titanium and the silicon substrate under a magnetic field by the magnetron, thus achieving a uniformity in a ratio of an amount of titanium deposited per unit area in the sputtering step and a thickness uniformity of the titanium layer 31.

Then the semiconductor structure as shown in Fig. 2B is heat treated, for example, for 0.5 to 1.0 hours at a temperature of 600 to 700°C in a nitrogen source gas atmosphere, such as nitrogen or ammonia, to effect a silicidation reaction. In this way, silicide layers 32 and 33 are formed beneath the bottoms of the contact holes 15 and 16 as shown in Fig. 2C. The silicidation reaction in the nitrogen source atmosphere can provide the silicide layers 32 and 33 of uniform thickness can be provided, as in Embodiment, without forming the titanium nitride layer 18 of Embodiment 1.

In the same way as set out in connection with Embodiment 1, a tungsten layer is deposited by a CVD method over titanium layers 32 and 33, and an interconnection layer is formed connecting with the corresponding contact regions, obtaining a semiconductor device.

This Embodiment 2 can gain the same advantages as in Embodiment 1. In actual practice, the contact region of Embodiment 2 revealed the electrical properties similar to that of the contact region obtained in Embodiment 1.

### Embodiment 3

As shown in Fig. 3A, impurity regions 12 and 13 are formed in a surface portion of a semiconductor silicon substrate 11, and an insulating layer 14 is formed on the substrate 11, as in Embodiment 1. Contact holes (only one (16) is shown in Fig. 3A for convenience sake) are formed in an insulating layer 14 to expose the impurity area 12 and impurity area 13, as in Embodiment 1.

Then a transition metal layer, such as titanium layer 41, is vapor deposited on a resultant semiconductor structure. The titanium layer preferably has a thickness of 500 to 1500 Å.

In the case where a transition metal, such as titanium, is deposited on the semiconductor substrate structure by a vapor deposition method, there is a tendency that more particles are oriented in a direction perpendicular to the surface of the substrate, and less transition metal is deposited on the side wall of the contact hole, than by a sputtering method. This tendency is more pronounced with the use of a single vapor deposition source than with the use of plural vapor deposition sources. According to the vapor deposition method, therefore, as shown in Fig. 3A, the titanium layer 41 is formed only on the surface of the insulating layer 14 and of the bottom of the contact hole 16 in which case the titanium layer on the bottom of the contact hole is thicker than that on the surface of the insulating layer 14. The formation of the transition metal layer by the vapor deposition method can be favorably applied particularly to the contact hole whose aspect ratio is greater.

Then the semiconductor structure of Fig. 3A is heat treated to produce a silicide layer 42 and a tungsten layer 43 is grown on the semiconductor structure, as in Embodiment 1 (Fig. 3B). The tungsten layer 43 is formed on the surface of the titanium layer 41 and in the contact hole 16. The remaining titanium layer 41 and unnecessary tungsten layer portion are eliminated by the etch-back step to leave a tungsten layer portion 43 only in the contact hole 16.

Prior to forming the tungsten layer 43, the remaining titanium layer 41 on the insulating layer 14 can be oxidized to provide a titanium oxide layer. When tungsten is grown by the CVD method in the same way as set out above, it is not so done on the titanium oxide layer, so that the tungsten layer is provided only in the contact hole 16. By removing the titanium oxide layer it is possible to obtain the same structure as shown in Fig. 3C.

After the tungsten layer is formed as a buried layer in the contact hole 16, an interconnection layer is connected to the corresponding contact region, as in Embodiment 1, thus producing a semiconductor device.

This Embodiment ensures the same advantages as those in Example 1. Those contact regions which are formed in accordance with Embodiment 3 revealed the same electrical property as that in Example 1.

## Claims

1. A method of forming a contact region in a semiconductor device, comprising the steps of:
forming an insulating layer (14) on a semiconductor substrate (11) having a predetermined semiconductor region formed in the surface portion thereof, said semiconductor substrate (11) comprising silicon;
providing a contact hole (15, 16) in said insulating layer (14), partially exposing said semiconductor region;
forming a transition metal layer (17, 31, 41) on the exposed semiconductor region;
forming a silicide layer (19, 20, 42) through a reaction of said transition metal layer (17, 31, 41) with said silicon in said substrate (11) within said contact hole (15, 16); and
forming a tungsten layer (21, 22, 43) by chemical vapour deposition on said silicide layer (19, 20, 42) on the bottom of the contact hole with sufficient depth to substantially reduce the depth to width ratio of the hole.

2. The method according to claim 1, characterized in that said transition metal layer (17, 31, 41) is formed by a sputtering.

3. The method according to claim 2, characterized in that said sputtering is a magnetron sputtering.

## Patentansprüche

1. Ein Verfahren zum Bilden eines Kontaktbereichs in einer Halbleitervorrichtung, das die Schritte umfaßt:
- Bilden einer Isolierschicht (14) auf einem Halbleitersubstrat (11) mit einem in dem Oberflächenanteil davon gebildeten vorbestimmten Halbleiterbereich, wobei das Halbleitersubstrat (11) Silizium umfaßt;
- Versehen eines Kontaktlochs (15, 16) in der Isolierschicht (14), teilweise den Halbleiterbereich freilegend;
- Bilden einer Übergangsmetallschicht (17, 31, 41) auf dem freiliegenden Halbleiterbereich;
- Bilden einer Silizidschicht (19, 20, 42) durch eine Reaktion der Übergangsmetallschicht (17, 31, 41) mit dem Silizium in dem Substrat (11) innerhalb des Kontaktlochs (15, 16); und
- Bilden einer Tungstenschicht (21, 22, 42) mit ausreichender Tiefe durch Gasphasenabscheidung auf der Silizidschicht (19, 20, 42) auf dem Boden des Kontaktlochs, um das Tiefe zu Weite-Verhältnis des Lochs wesentlich zu vermindern.

2. Das Verfahren gemäß Anspruch 1,
dadurch **gekennzeichnet,** daß die Übergangsmetallschicht (17, 31, 41) durch ein Sputtern gebildet wird.

3. Das Verfahren gemäß Anspruch 2,
dadurch **gekennzeichnet,** daß das Sputtern ein Magnetronsputtern ist.

## Revendications

1. Un procédé de formation d'une région de contact dans un dispositif à semiconducteurs comprenant les étapes suivantes :
on forme une couche isolante (14) sur un substrat semiconducteur (11) ayant une région de semiconducteur prédéterminée formée dans sa partie de surface, ce substrat semiconducteur (11) consistant en silicium;
on forme un trou de contact (15, 16) dans la couche isolante (14), pour mettre partiellement à nu la région de semiconducteur;
on forme une couche de métal de transition (17, 31, 41) sur la région de semiconducteur à nu;
on forme une couche de siliciure (19, 20, 42), par une réaction de la couche de métal de transition (17, 31, 41) avec le silicium dans le substrat (11), à l'intérieur du trou de contact (15, 16); et
on forme une couche de tungstène (21, 22, 43), par dépôt chimique en phase vapeur sur la couche de siliciure (19, 20, 42), sur le fond du trou de contact, avec une profondeur suffisante pour réduire notablement le rapport de la profondeur à la largeur du trou.

2. Le procédé selon la revendication 1, caractérisé en ce que l'on forme la couche de métal de transition (17, 31, 41) par pulvérisation cathodique.

3. Le procédé selon la revendication 2, caractérisé en ce que la pulvérisation cathodique est une pulvérisation cathodique par magnétron.
